(19) Europäisches Patentamt / European Patent Office / Office européen des brevets

(11) **EP 2 822 198 B1**

(12) **FASCICULE DE BREVET EUROPEEN**

(45) Date de publication et mention
de la délivrance du brevet:
**21.12.2016 Bulletin 2016/51**

(51) Int Cl.:
**H04B 17/00** $^{(2015.01)}$    **G01S 7/40** $^{(2006.01)}$

(21) Numéro de dépôt: **14175850.8**

(22) Date de dépôt: **04.07.2014**

(54) **Système de mesure du temps de propagation de groupe d'une antenne et procédé de mesure associé**

Verfahren und Vorrichtung zur Messung der Gruppenlaufzeit einer Antenne

Method and System to measure the group delay of an antenna

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **04.07.2013 FR 1356562**

(43) Date de publication de la demande:
**07.01.2015 Bulletin 2015/02**

(73) Titulaire: **CENTRE NATIONAL D'ETUDES
SPATIALES
75001 Paris (FR)**

(72) Inventeurs:
• **Belot, Daniel
  31490 Leguevin (FR)**
• **Lopez, Jean-Marc Emile
  31450 Corronsac (FR)**
• **Feat, Lise
  31470 Saint Lys (FR)**

(74) Mandataire: **Lavoix
2, place d'Estienne d'Orves
75441 Paris Cedex 09 (FR)**

(56) Documents cités:
**JP-A- 2007 033 093    US-A- 2 786 198
US-A1- 2006 291 537**

• **OSAKI H ET AL: "Measurement of ultra wideband
radar cross sections of an automobile at Ka band
using circular polarizations", IEICE
TRANSACTIONS ON FUNDAMENTALS OF
ELECTRONICS,COMMUNICATIONS AND
COMPUTER SCIENCES, ENGINEERING
SCIENCES SOCIETY, TOKYO, JP, vol. E91A, no.
11, 1 novembre 2008 (2008-11-01), pages
3190-3196, XP001517404, ISSN: 0916-8508, DOI:
10.1093/IETFEC/E91-A.11.3190**

**Description**

La présente invention concerne un système de mesure du temps de propagation de groupe d'une antenne apte à émettre et/ou à recevoir une onde électromagnétique de polarisation donnée et un procédé de mesure de temps de propagation de groupe d'antenne associé.

L'invention se situe dans le domaine de la caractérisation des antennes, et trouve de nombreuses applications, notamment dans les domaines des télécommunications, de la navigation aéronautique et spatiale, de la localisation et de l'altimétrie radar.

Dans ces divers domaines, des antennes sont utilisées pour le rayonnement dans l'espace d'une onde électromagnétique en mode émission et la collecte d'une onde électromagnétique reçue en mode réception. Il s'agit d'une configuration dite configuration en espace libre. L'onde électromagnétique traversant une antenne subit un retard dû à son trajet à l'intérieur de l'antenne, appelé temps de propagation de groupe. Il est particulièrement difficile d'évaluer le temps de propagation de groupe d'une antenne par calcul théorique, car pour un grand nombre d'antennes il n'est pas possible de modéliser le trajet de l'onde électromagnétique à l'intérieur de l'antenne.

Pour de nombreuses applications, il est important de connaître avec précision le temps de propagation de groupe (connu en anglais sous le nom de « group delay ») des antennes.

On connaît un procédé de mesure du temps de propagation de groupe pour une antenne à polarisation linéaire ou circulaire, qui consiste à utiliser trois antennes quelconques à polarisation linéaire ou circulaire dont les caractéristiques sont inconnues. Ces antennes sont mesurées deux à deux, ce qui fournit un système d'équations permettant de calculer le temps de propagation de groupe de chacune des antennes.

Il est également connu un procédé de mesure des caractéristiques inconnues d'une antenne, notamment son temps de propagation de groupe, en utilisant une antenne dite antenne étalon dont les caractéristiques sont connues. L'inconvénient principal de ce procédé est la nécessité de disposer d'une antenne étalon dont les caractéristiques sont connues.

Récemment, l'utilisation des antennes ultra large bande, dites également antennes UWB pour Ultra Wide Band, en polarisation circulaire, s'est largement développée. Il est particulièrement difficile d'évaluer le temps de propagation de groupe de telles antennes en espace libre, du fait de leur polarisation circulaire et de leur sensibilité aux multi trajets.

La demande de brevet US 2006/291537 décrit une méthode de calcul de temps de propagation entre un transmetteur UWB (« Ultrawide band ») et un récepteur UWB.

Le document JP2007033093 décrit une mesure de retard entre une antenne de transmission et une antenne de réception.

L'invention a pour objet de proposer un système et un procédé de mesure du temps de propagation de groupe d'une antenne qui soit fiable, notamment applicable à des antennes à polarisation circulaire et ne nécessitant pas l'utilisation d'une antenne étalon à caractéristiques connues.

A cet effet, l'invention propose, selon un premier aspect, un système de mesure du temps de propagation de groupe d'une antenne à mesurer apte à fonctionner en émission et/ou en réception d'une onde électromagnétique de polarisation donnée, tel que revendiqué dans la revendication 1.

Avantageusement, le système de mesure d'un temps de propagation de groupe d'antenne selon l'invention comprend un système de réflexion conservateur de polarisation, permettant d'obtenir une onde électromagnétique réfléchie de même polarisation circulaire que l'onde électromagnétique incidente, permettant ainsi une mesure pour une antenne à polarisation circulaire. De plus, le procédé fonctionne également pour une antenne à polarisation linéaire.

Le système de l'invention permet la mesure du temps de propagation de groupe d'une antenne apte à fonctionner en émission et en réception sans utilisation d'une antenne étalon à caractéristiques connues. Ainsi, l'invention s'applique pour l'étalonnage de la caractéristique de temps de propagation de groupe pour une antenne quelconque.

Le système de mesure d'un temps de propagation de groupe selon l'invention peut également présenter une ou plusieurs des caractéristiques selon les revendications dépendantes.

Selon un deuxième aspect, l'invention concerne un procédé de mesure d'un temps de propagation de groupe d'une antenne à mesurer apte à fonctionner en émission et/ou en réception d'une onde électromagnétique de polarisation donnée tel que revendiqué dans la revendication 9, mis en oeuvre par un système de mesure du temps de propagation de groupe tel que brièvement décrit ci-dessus.

D'autres caractéristiques et avantages de l'invention ressortiront de la description qui en est donnée ci-dessous, à titre indicatif et nullement limitatif, en référence aux figures annexées, parmi lesquelles :

- la figure 1 est une illustration schématique d'un système de mesure du temps de propagation de groupe à deux antennes ;
- la figure 2 une vue en perspective d'un système de mesure du temps de propagation de groupe d'une antenne selon un premier mode de réalisation décrit ;
- la figure 3 est une vue schématique du système de la figure 2 ;
- la figure 4 est une vue schématique d'un système de mesure de temps de propagation de groupe d'une antenne selon un deuxième mode de réalisation décrit;

- la figure 5 est une vue schématique d'un système de mesure de temps de propagation de groupe d'une antenne selon un troisième mode de réalisation décrit, et
- la figure 6 illustre un quatrième mode de réalisation décrit.

L'invention sera décrite plus particulièrement dans son application à une antenne ultra large bande à polarisation circulaire et à diagramme d'antenne peu directif.

Cependant, l'invention s'applique également aux antennes à polarisation linéaire, et en particulier aux antennes à diagramme d'antenne directif et à polarisation linéaire ou circulaire.

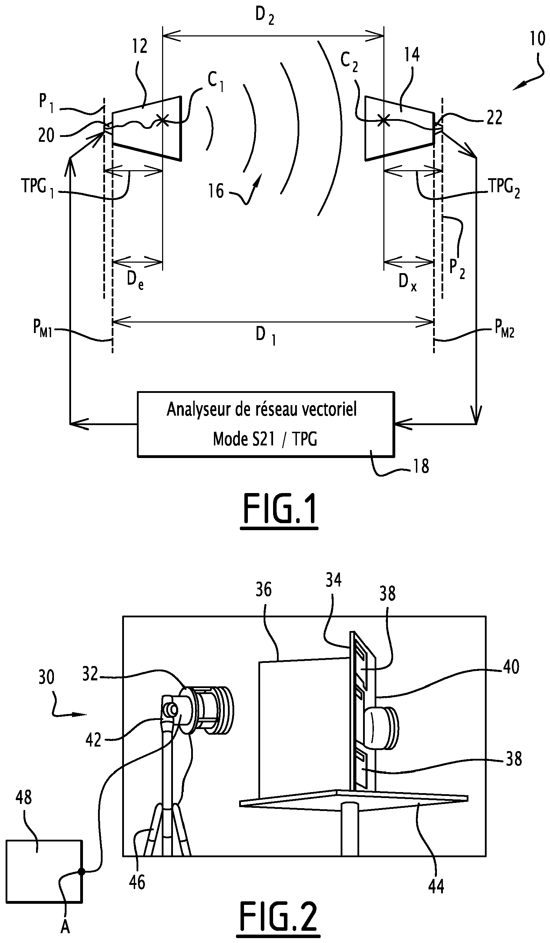

La figure 1 illustre de manière schématique un système 10 de mesure de temps de propagation de groupe classique, comportant deux antennes 12, 14, positionnées en regard, l'antenne 12 fonctionnant en émission et l'antenne 14 fonctionnant en réception.

Une onde électromagnétique radiofréquence 16 est rayonnée dans l'espace libre entre les deux centres de phase des antennes 12 et 14 identifiés pour la ligne de visée.

Un instrument de mesure d'antennes, qui est dans ce mode de réalisation un analyseur de réseau vectoriel 18, branché entre un connecteur 20 de l'antenne 12 et un connecteur 22 de l'antenne 14 est utilisé pour mesurer les paramètres S du quadripôle formé par le système d'antennes 12, 14.

L'onde électromagnétique 16 se propage à l'intérieur de l'antenne 12, entre le connecteur 20 situé au niveau d'un plan P1, qui est le plan de référence d'émission, et un point C1 qui est le centre de phase de l'antenne 12, puis en espace libre jusqu'au point C2, centre de phase de l'antenne 14, et enfin à l'intérieur de l'antenne 14 jusqu'au connecteur 22 situé au niveau d'un plan P2, qui est le plan de référence de réception.

Le temps de propagation de groupe de l'antenne 12, $TPG_1$, est le temps de propagation de l'onde électromagnétique à l'intérieur de l'antenne 12, entre le plan P1 et le centre de phase C1.

De manière analogue, le temps de propagation de groupe $TPG_2$ à l'intérieur de l'antenne 14 est le temps de propagation de l'onde électromagnétique entre le centre de phase C2 et le plan P2.

La distance $D_1$ entre des plans de référence mécaniques $P_{M1}$, $P_{M2}$ des antennes 12, 14 est mesurée par utilisation d'un lasermètre ou tout autre moyen de mesure approprié (par exemple, un mètre à ruban, une perche de longueur calibrée et connue et terminée à une de ses extrémités par une jauge de profondeur).

La distance $D_2$ entre les centres de phase C1 et C2 de propagation en espace libre est calculée, connaissant les distances notées De, $D_x$ et $D_1$ et est obtenue à partir de la formule $D_2 = D_1 - D_e - D_x$. La distance notée De est la distance entre le plan de référence mécanique $P_{M1}$ de l'antenne 12 et le centre de phase C1, et la distance notée $D_x$ est la distance entre le plan de référence mécanique $P_{M2}$ de l'antenne 14 et le centre de phase C2.

Le système 10 de la figure 1 est utilisable pour mesurer les caractéristiques d'une des antennes 12, 14, par exemple le temps de propagation de groupe de l'antenne 12, lorsque les caractéristiques de l'autre antenne, par exemple l'antenne 14, sont connues. Dans ce cas, l'antenne 14 est utilisée comme antenne étalon pour la mesure du temps de propagation de groupe de l'antenne 12. Afin de garantir la précision de mesure, il est donc nécessaire dans ce cas de connaître les caractéristiques de l'antenne étalon avec une très grande précision.

Le $TPG_1$ recherché se déduit de l'équation : $TPG_1 = TPG - TPG_{EL} - TPG_2$, où TPG est le temps de propagation total entre les connecteurs 20, 22, mesuré par l'analyseur de réseau vectoriel 18, $TPG_{EL}$ est le temps de propagation entre les centres de phase C1, C2, et $TPG_1$ et $TPG_2$ sont les temps de propagation de groupe respectifs des antennes 12 et 14 définis ci-dessus.

Alternativement, si les deux antennes 12, 14 sont strictement identiques, donc les temps de propagation de groupe $TPG_1$ et $TPG_2$ sont identiques, il est possible également d'utiliser un tel système pour la mesure du temps de propagation de groupe.

L'invention s'attache à proposer un système de mesure de temps de propagation de groupe qui ne nécessite pas l'utilisation d'une antenne étalon ni la mise en oeuvre de deux antennes identiques.

Selon le mode de réalisation illustré à la figure 2, un système 30 de mesure du temps de propagation de groupe d'une antenne 32 utilise un système de réflexion 34, qui est un dièdre métallique dans ce mode de réalisation. Le dièdre 34 est positionné dans la direction de visée de l'antenne 32.

Avantageusement, un système de réflexion d'onde électromagnétique conservateur de polarisation selon l'invention est, dans ce mode de réalisation, apte à effectuer un nombre pair de réflexions de l'onde, ce qui permet de conserver après réflexion le même sens de polarisation circulaire que l'onde électromagnétique incidente polarisée circulairement.

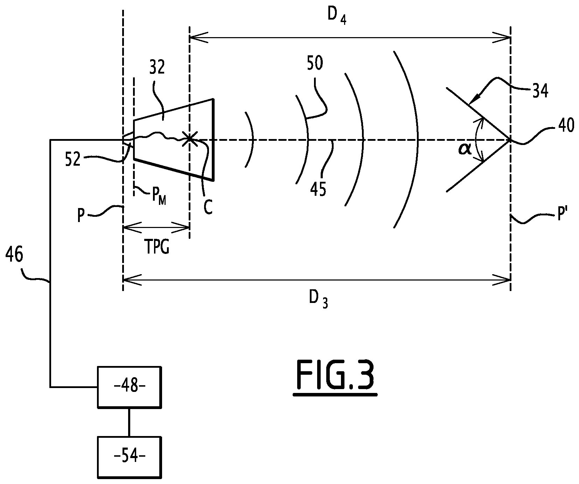

Le dièdre 34 est constitué de deux faces métalliques planes 36, 38, positionnées selon un angle α visible en figure 3, se joignant au niveau d'une arête centrale 40. L'angle α est sensiblement égal à 90°. La direction de visée de l'antenne 32 pointe vers l'arête centrale 40 du dièdre 34.

Lorsque l'onde électromagnétique incidente émise par l'antenne 32 est une onde circulaire à polarisation droite (respectivement gauche), après réflexion sur une première face 36 du dièdre 34 cette polarisation est transformée en polarisation circulaire gauche (respectivement droite). La réflexion sur la deuxième face 38 du dièdre inverse à nouveau la polarisation, générant une onde électromagnétique réfléchie de polarisation circulaire droite (respectivement gauche). L'antenne 32 reçoit en réception une onde électromagnétique réfléchie par le dièdre 34, de même polarisation circulaire que l'onde incidente. Le déphasage dû localement aux réflexions est de $2\pi$ (en degrés 180° + 180°), sans influence sur le temps de propagation de groupe.

Comme illustré à la figure 2, dans le système 30 de mesure du temps de propagation de groupe (TPG), l'antenne 32 est fixée sur un support 42, et positionnée en regard de l'arête centrale 40 interne du dièdre 34. Le dièdre 34 est lui-même positionné sur un support 44.

En effet, pour une gamme d'angles d'incidence donnée, la réflexion par le dièdre 34 se réalise à une distance équivalente de celle de l'arête 40, c'est-à-dire comme si l'onde électromagnétique incidente était réfléchie, à même sens de polarisation circulaire, par un plan P' perpendiculaire à la direction de propagation de l'onde incidente et qui passe par l'arête 40 (voir figure 3). L'angle d'incidence sur le dièdre doit rester dans une gamme de quelques degrés autour du plan bissecteur.

De préférence, l'intérieur du dièdre est parfaitement conducteur, par exemple métallique ou en mousse recouverte d'une couche métallique, et ses faces parfaitement planes.

De préférence, les dimensions des faces du dièdre 34 sont d'au moins deux longueurs d'onde, l'orthogonalité des faces internes étant de 90+/-0,1°.

La distance de positionnement entre le plan de réflexion P' du dièdre 34 et le plan d'émission-réception P de l'antenne 32, notée distance D3 sur la figure 3, est fixée. Le plan P' est le plan passant par l'arête centrale 40 du dièdre 34 et orthogonal à la direction de visée de l'antenne 32. De préférence l'antenne 32 est alignée précisément à l'aide d'un faisceau laser placé au niveau de l'antenne 32 et pointant l'arête 40 du dièdre 34. Inversement, le dièdre 34 peut être aligné à l'aide d'un faisceau laser situé au niveau du dièdre et pointant vers le centre de l'antenne 32. Tout instrument et toute méthode permettant de réaliser cet alignement sont valables. Les deux faces métalliques 36 et 38 doivent faire chacune un angle égal à l'angle $\alpha/2$ avec la ligne de visée 45.

L'antenne 32 est reliée via un câble 46 à un analyseur de réseau vectoriel 48, calibré en amplitude et en phase sur un port, par exemple le port A, apte à mesurer les caractéristiques de l'antenne 32. La mesure est réalisée en réflexion (S11 ou S22) dans la bande de fonctionnement de l'antenne 32.

Comme illustré schématiquement à la figure 3, le système 30 permet la mesure du temps de propagation de groupe TPG de l'antenne 32.

En effet, l'analyseur de réseau vectoriel 48 permet de mesurer le temps de propagation aller-retour de l'onde électromagnétique 50, au niveau du connecteur 52 de l'antenne 32, appelé temps total de parcours et noté $T_{tot}$. De préférence, l'analyseur de réseau vectoriel 48 est utilisé selon une option de traitement temporel (« time domain ») qui permet de localiser avec précision le maximum du signal correspondant à l'onde électromagnétique réfléchie par le dièdre 34.

Le temps $T_{tot}$ est le temps de parcours aller-retour de la distance D3, qui est la distance entre le plan P du connecteur 52 de l'antenne 32 et le plan P' de l'arête 40 du dièdre 34.

Le système 30 comporte également des moyens de calcul 54, par exemple mis en oeuvre par un ordinateur, aptes à calculer le temps de propagation de groupe recherché à partir des valeurs de temps de propagation mesurées, comme détaillé ci-après.

Le temps de propagation de groupe TPG est calculé à partir du temps total de propagation aller-retour $T_{tot}$ et du temps de trajet aller-retour en espace libre, noté $T_{el}$, selon la formule :

$$TPG = \frac{T_{tot} - T_{el}}{2}$$

Le temps de trajet aller-retour en espace libre correspond au temps mis par l'onde électromagnétique incidente à traverser la distance D4 à l'aller et par l'onde électromagnétique réfléchie à traverser la distance D4 au retour vers l'antenne 32.

Comme visible sur la figure 3, la distance D4 est la distance entre un point de référence C prédéfini de l'antenne 32, qui est le centre de phase C de l'antenne 32 dans ce mode de réalisation, et dans la direction du dièdre, et le plan P' de l'arête 40 du dièdre 34.

La mesure de la distance D4, entre le point de référence C et l'arête 40 du dièdre, est réalisée à l'aide d'un instrument adapté, par exemple un lasermètre ou un mètre à ruban, qui donne la distance entre l'arête du dièdre et un plan de référence mécanique $P_M$ que l'on rallie au centre de phase.

La position géométrique du centre de phase C de l'antenne 32 à caractériser, qui change selon la direction visée, est identifiée par une méthode connue, par exemple par la mesure. Lorsque le diagramme de phase mesuré présente des variations minimales dans une gamme d'angles donnés, l'origine du repère de mesure est alors placée au centre de phase, ce qui permet de connaître sa position par rapport à un point de référence de l'antenne. La position géométrique du centre de phase peut aussi être déterminée par calcul à l'aide de logiciels de modélisation spécifiques ou commerciaux. Toute méthode connue de détermination de la position géométrique du centre de phase selon la direction visée est applicable.

De préférence, une méthode permettant de localiser le centre de phase avec une précision de l'ordre de 0,5 mm (millimètres) est appliquée.

Alternativement, pour une antenne de type cornet ou pour une antenne à réflecteur(s) par exemple une antenne paraboloïde, le point de référence C est un point de l'ouverture rayonnante. L'ouverture rayonnante est le plan de l'embouchure du cornet perpendiculaire à la direction de visée ou le plan perpendiculaire à la direction de visée et comprenant un point du réflecteur. Dans ce mode de réalisation alternatif, le système de mesure du temps de propagation de groupe fonctionne lorsque l'onde électromagnétique propagée entre l'antenne et le dièdre est aussi une onde plane.

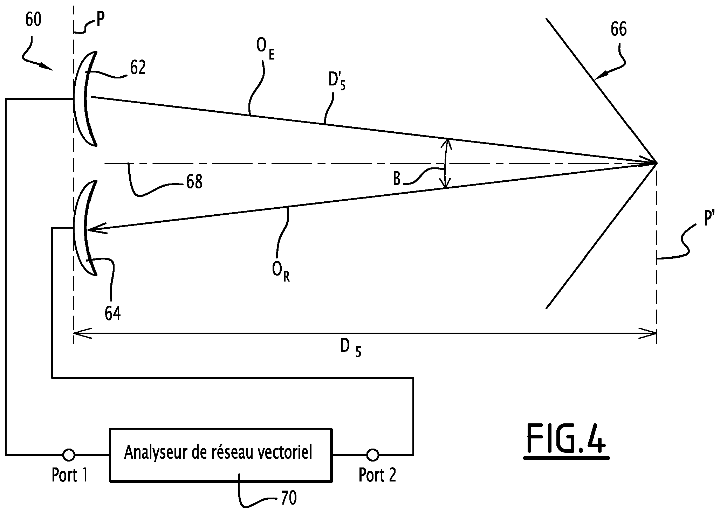

La figure 4 illustre un mode de réalisation alternatif de l'invention dans lequel le temps de propagation de groupe est mesuré pour deux antennes identiques de caractéristiques (temps de propagation de groupe) inconnues ou deux antennes dont une est déjà calibrée en temps de propagation de groupe.

Le système 60 de la figure 4 comporte deux antennes, notées 62, 64, positionnées côte à côte, aptes à émettre à partir d'un même plan P d'émission-réception, et orientées vers un système de réflexion 66, qui est un dièdre comme dans le mode de réalisation décrit en référence aux figures 2 et 3.

L'antenne 62 fonctionne en émission, et l'antenne 64 fonctionne en réception. Ainsi, dans ce mode de réalisation, contrairement au mode de réalisation décrit précédemment en référence aux figures 2 et 3, il n'est pas nécessaire que l'antenne dont on cherche à mesurer le temps de propagation de groupe fonctionne à la fois en émission et en réception. Ainsi, l'antenne 62 peut par exemple être une antenne active de télémesure d'image, et l'antenne 64 une antenne passive ou active en réception.

Les ondes électromagnétiques $O_E$ émises par l'antenne 62, par exemple en polarisation circulaire droite, se réfléchissent sur le dièdre 66 et se transforment en ondes électromagnétiques $O_R$ réfléchies, également en polarisation circulaire droite, reçues par l'antenne 64. L'angle B formé entre les directions de visée respectives des antennes 62 et 64 est appelé angle de bistatisme.

Un angle correspondant au demi-angle de bistatisme B/2 entre la bissectrice 68 du dièdre 66 et la ligne de visée de chaque antenne est mesurable. Par exemple, cet angle vaut 2°. Le diagramme de gain et le centre de phase de chaque antenne 62, 64 restent inchangés par rapport à un positionnement à 0°.

Les antennes 62, 64 sont connectées à des ports différents d'un analyseur de réseau vectoriel 70, comme illustré à la figure 4. Il est entendu que le système de mesure de temps de propagation de groupe 60 comporte également des moyens de calcul, analogues aux moyens de calcul 54, non représentés sur la figure 4.

L'antenne 62 a un temps de propagation de groupe TPG1 et l'antenne 64 a un temps de propagation de groupe TPG2.

Lorsque les deux antennes 62, 64 sont identiques, les temps de propagation de groupe le sont également : TPG1=TPG2.

Il suffit de prendre en compte l'allongement du trajet des ondes électromagnétiques émise et réfléchie en fonction de l'angle de bistatisme B dans le formules décrites précédemment en référence aux figures 2 et 3.

En effet, si les antennes 62, 64 sont situées à une distance $D'_5$ de l'arête du dièdre 66, $D_5$ étant la distance entre l'arête du dièdre 66 et le plan d'émission P, l'allongement de la distance de trajet d'une onde électromagnétique dû à l'angle de bistatisme est de :

$$d = D'_5 - D_5 = \frac{D_5}{\cos(B/2)} - D_5.$$ La distance d correspond à un allongement de temps de trajet de t = d/c, où c est la vitesse de l'onde électromagnétique.

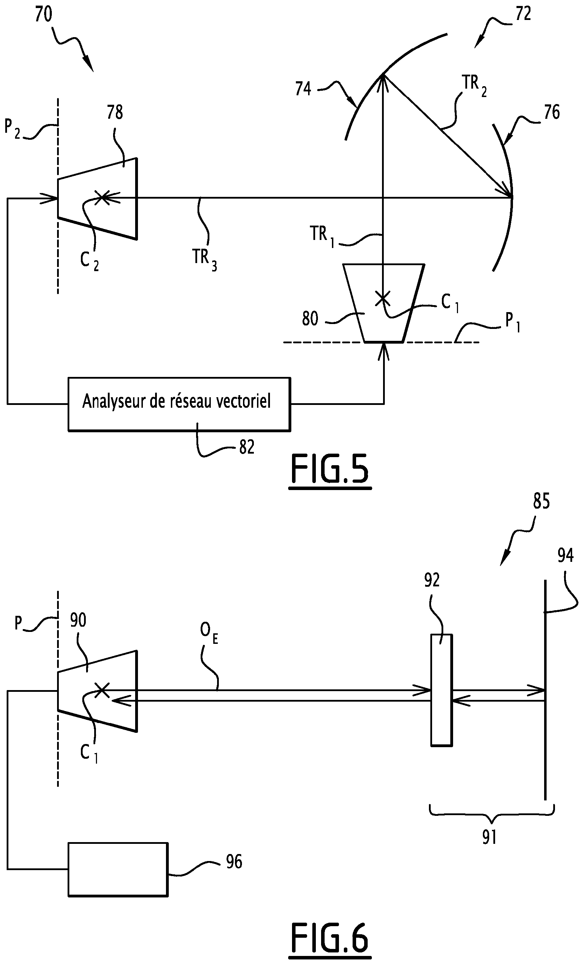

La figure 5 décrit un mode alternatif à celui de la figure 4. Le système de mesure de temps de propagation de groupe 70 comporte un système de réflexion 72 à deux réflecteurs 74, 76, le réflecteur 74 étant de type hyperbolique, le réflecteur 76 étant parabolique. L'antenne 78 est l'antenne à mesurer. L'antenne 80, placée à l'un des foyers du réflecteur 74, est connue ou similairement à la figure 4 est identique à l'antenne 78. Le réflecteur 74 est placé au foyer du réflecteur 76. La distance entre les plans P1 et P2 à travers le système optique hyperfréquence, distance parcourue par l'onde électromagnétique entre le plan d'émission P1 et le plan de réception P2, est mesurable à l'aide d'un instrument approprié (laser mètre, laser tracker...) ou calculée à partir de la connaissance mathématique des réflecteurs, leurs positions étant connues. Le sens de la polarisation de l'onde émise par l'antenne 80 est conservé du fait de la double réflexion sur les réflecteurs 74, 76 au niveau de l'antenne 78. L'analyseur de réseau vectoriel 82 mesure le temps de propagation entre P1 et P2. Pour obtenir le temps de propagation dans l'antenne 78 il faut enlever au temps mesuré le temps de propagation à l'intérieur de l'antenne 80 (de P1 à C1), les temps de propagation en espace libre des trajets notés TR1, TR2 et TR3. Il est entendu que le système de mesure de temps de propagation de groupe 70 comporte également des moyens de calcul, analogues aux moyens de calcul 54, non représentés sur la figure 5.

Alternativement, on peut envisager une configuration dans laquelle le réflecteur 74 serait un plan conducteur placé à 45° de la ligne de visée du trajet TR1.

La figure 6 illustre un autre mode, dans lequel le système de mesure de temps de propagation de groupe 85 utilise une réflexion impaire et ne nécessite pas d'antenne de référence. Il permet la mesure de TPG de l'antenne à mesurer 90 qui fonctionne à l'émission et à la réception en polarisation circulaire. La conservation du sens de la polarisation circulaire de l'onde réfléchie est réalisée par la mise en place du système de réflexion 91 comportant un système polarisant 92 comme un polariseur à lame ou fil, ou à ligne imprimée sur un substrat tel un polariseur à méandre, ou même un polariseur à empilement de couches, derrière lequel est positionné un plan réflecteur 94, en matériau conducteur. Le principe de la mesure est identique à celui décrit pour la figure 3 en rajoutant le temps de trajet de l'onde pour traverser le système polarisant 92. Ce temps de trajet est soit mesurable à l'aide d'un système de mesure adéquat, soit calculable connaissant son épaisseur(s) et la ou les valeur(s) des constantes diélectriques des matériaux qui le constituent. Il est important d'assurer l'orthogonalité entre le plan réflecteur 94 et la ligne de visée de l'antenne 90. L'onde incidente $O_E$ polarisée circulairement issue de l'antenne à mesurer après la traversée du système polarisant 92 devient linéaire, est réfléchie par le plan conducteur tout en restant linéaire et redevient circulaire à la seconde traversée du polariseur avant de revenir en tant qu'onde $O_R$ sur l'antenne 90.

Le temps de propagation total aller-retour est mesuré par l'analyseur de réseau vectoriel 96, branché sur un connecteur de l'antenne à mesurer 90, au niveau d'un plan de référence d'émission-réception P. Il est entendu que le système de mesure de temps de propagation de groupe 85 comporte également des moyens de calcul, analogues aux moyens de calcul 54, non représentés sur la figure 6.

Dans les exemples de modes de réalisation de l'invention illustrés ci-dessus, le système de réflexion conservateur de polarisation est un système de réflexion à deux éléments intervenant sur le trajet de l'onde électromagnétique, qui sont soit deux éléments réflecteurs, par exemple les parois conductrices d'un dièdre 34, 66, soit les deux réflecteurs 74, 76, soit un système polarisant traversé par l'onde électromagnétique et un réflecteur plan.

De manière générale, il est envisageable d'utiliser, dans le système de réflexion conservateur de polarisation, un nombre pair d'éléments optiques supérieur à deux. Cependant, l'utilisation d'un système de réflexion à deux éléments optiques permet d'éviter d'introduire une trop forte atténuation entre onde incidente et onde réfléchie.

## Revendications

1. Système (30, 60, 70, 85) de mesure du temps de propagation de groupe d'une antenne à mesurer apte à fonctionner en émission et/ou en réception d'une onde électromagnétique de polarisation donnée, le système comportant une antenne (62, 80) d'émission et une antenne (64, 78) de réception, les antennes étant connectées à un instrument (48, 70, 82, 96) de mesure d'antennes,
comportant un système de réflexion (34, 66, 72, 91), ledit système de réflexion étant un système conservateur de polarisation, comportant au moins deux d'éléments intervenant sur le trajet de l'onde électromagnétique, positionné dans la direction de visée des antennes, à une distance prédéterminée d'un plan de référence d'émission ou de réception de l'antenne à mesurer, **caractérisé en ce que** le système de réflexion (34, 66, 72, 91) est apte à réfléchir une onde électromagnétique incidente de polarisation circulaire ayant un sens de polarisation donné en une onde électromagnétique réfléchie de polarisation circulaire ayant le même sens de polarisation que l'onde électromagnétique incidente, le système de réflexion conservateur de polarisation étant un dièdre (34, 66) conducteur, ayant une arête centrale (40), et la direction de visée de chacune des antennes pointant vers l'arête centrale du dièdre.

2. Système selon la revendication 1, **caractérisé en ce que** le système de réflexion (34, 66, 72, 91) conservateur de polarisation comporte un nombre pair d'éléments réflecteurs aptes à réfléchir une onde électromagnétique incidente un nombre pair de fois.

3. Système selon l'une des revendications 1 ou 2, **caractérisé en ce que** ledit instrument (48, 70, 82, 96) de mesure est apte à mesurer un temps total de propagation aller-retour d'une onde électromagnétique émise par l'antenne (32, 62, 80) apte à fonctionner en émission et reçue après réflexion par ledit système de réflexion (34, 66, 72, 91) conservateur de polarisation par l'antenne (32, 64, 78, 90) apte à fonctionner en réception.

4. Système selon la revendication 3, **caractérisé en ce qu'**il comporte des moyens de calcul (54) aptes à calculer un temps de propagation de groupe de ladite antenne à mesurer en fonction du temps total de propagation aller-retour mesuré.

5. Système selon la revendication 4, **caractérisé en ce que** lesdits moyens de calcul (54) mettent en oeuvre un temps de propagation en espace libre de l'onde électromagnétique émise, égal au temps de propagation entre un point spatial de référence (C, C1) de l'antenne (32, 62, 90) fonctionnant en émission et un plan de réflexion (P') dudit système de réflexion, et un temps de propagation en espace libre de l'onde électromagnétique réfléchie, égal au temps de propagation entre le plan de réflexion (P') dudit système de réflexion et un point spatial de référence (C, C2) de l'antenne (32, 64, 90) fonctionnant en réception.

6. Système selon la revendication 5, comportant une seule antenne (32, 90) à polarisation circulaire apte à fonctionner en émission et en réception, **caractérisé en ce que** ledit point de référence (C) est situé au centre de phase de l'antenne.

7. Système selon la revendication 5, comportant une seule antenne (32, 90) à polarisation linéaire apte à fonctionner en émission et en réception, **caractérisé en ce que** ledit point de référence (C) est une ouverture de référence de l'antenne.

8. Système selon la revendication 5, comportant deux antennes (62, 64) différentes, positionnées dans un même plan (P) d'émission-réception, **caractérisé en ce qu'**une onde électromagnétique émise par l'antenne (62) apte à fonctionner en émission est réfléchie par ledit système de réflexion (34) en une onde électromagnétique réfléchie apte à être reçue par l'antenne (64) fonctionnant en réception, lesdites ondes électromagnétiques émise et réfléchie formant un angle de bistatisme, et **en ce que** la valeur de l'angle de bistatisme est prise en compte par les moyens de calcul du temps de propagation de groupe.

9. Procédé de mesure du temps de propagation de groupe d'une antenne à mesurer apte à fonctionner en émission et/ou en réception d'une onde électromagnétique de polarisation donnée, mis en oeuvre par un système de mesure du temps de propagation de groupe selon la revendication 1, **caractérisé en ce qu'**il comporte les étapes suivantes :

- émission d'une onde électromagnétique par l'antenne d'émission, vers un système de réflexion conservateur de polarisation, le système de réflexion conservateur de polarisation étant un dièdre (34, 66) conducteur, ayant une arête centrale (40), et la direction de visée de chacune des antennes pointant vers l'arête centrale du dièdre,
- réflexion de l'onde électromagnétique émise en onde électromagnétique réfléchie par le système de réflexion, l'onde électromagnétique réfléchie ayant, lorsque l'onde électromagnétique incidente est une onde de polarisation circulaire ayant un sens de polarisation donné, le même sens de polarisation que l'onde électromagnétique incidente,
- réception par l'antenne de réception, d'une onde électromagnétique réfléchie par ledit système de réflexion,
- mesure du temps total de propagation aller-retour de l'onde électromagnétique, et
- calcul du temps de propagation de groupe de l'antenne à mesurer en fonction du temps aller-retour mesuré et de la distance prédéterminée.

10. Procédé selon la revendication 9, **caractérisé en ce que** l'antenne d'émission et l'antenne de réception ont un temps de propagation de groupe identique.

11. Procédé selon la revendication 9, **caractérisé en ce que** l'émission est effectuée par une antenne d'émission et que la réception est effectuée par l'antenne à mesurer, l'antenne d'émission ayant un temps de propagation de groupe connu.

12. Procédé selon la revendication 9, **caractérisé en ce que** l'émission est effectuée par l'antenne à mesurer et que la réception est effectuée par une antenne de réception, l'antenne de réception ayant un temps de propagation de groupe connu.

**Patentansprüche**

1. System (30, 60, 70, 85) zum Messen der Gruppenausbreitungszeit einer zu vermessenden Antenne, die im Sende- und/oder im Empfangsbetrieb für eine elektromagnetische Welle mit gegebener Polarisation arbeiten kann, wobei das System eine Sendeantenne (62, 80) und eine Empfangsantenne (64, 78) umfasst, wobei die Antennen mit einem Antennenmessinstrument (48, 70, 82, 96) verbunden sind, das umfasst: ein Reflexionssystem (34, 66, 72, 91), wobei das Reflexionssystem ein Polarisationsaufrechterhaltungssystem ist, das wenigstens zwei Elemente enthält, die auf die Bahn der elektromagnetischen Welle einwirken, und in der Strahlrichtung der Antennen in einem vorgegebenen Abstand von einer Sende- oder Empfangsreferenzebene der zu vermessenden Antenne positioniert ist, **dadurch gekennzeichnet, dass** das Reflexionssystem (34, 66, 72, 91) eine auftreffende elektromagnetische Welle mit zirkulärer Polarisation mit einer gegebenen Polarisationsrichtung in eine reflektierte elektromagnetische Welle mit zirkulärer Polarisation mit derselben Polarisationsrichtung wie die auftreffende elektromagnetische Welle reflektieren kann, wobei das Reflexionssystem mit Polarisationsaufrechterhaltung ein leitendes Zweiflach (34, 66) ist, das eine Mittelkante (40) aufweist, wobei die Strahlrichtung jeder der Antennen zu der Mittelkante des Zweiflachs zeigt.

2. System nach Anspruch 1, **dadurch gekennzeichnet, dass** das Reflexionssystem (34, 66, 72, 91) mit Polarisationsaufrechterhaltung eine gerade Anzahl von Reflektorelementen enthält, die eine auftreffende elektromagnetische Welle in einer geraden Anzahl von Malen reflektieren können.

3. System nach einem der Ansprüche 1 oder 2, **dadurch gekennzeichnet, dass** das Messinstrument (48, 70, 82, 96) die Gesamtausbreitungszeit für Hin- und Rücklauf einer elektromagnetischen Welle, die von der Antenne (32, 62, 80, 90), die im Sendebetrieb arbeiten kann, ausgesendet wird und nach Reflexion durch das Reflexionssystem (34, 66, 72, 91) mit Polarisationsaufrechterhaltung durch die Antenne (32, 64, 78, 90), die im Empfangsbetrieb arbeiten kann, empfangen wird, messen kann.

4. System nach Anspruch 3, **dadurch gekennzeichnet, dass** es Rechenmittel (54) umfasst, die eine Gruppenausbreitungszeit der zu vermessenden Antenne als Funktion der gemessenen Gesamtausbreitungszeit für Hin- und Rücklauf berechnen kann.

5. System nach Anspruch 4, **dadurch gekennzeichnet, dass** die Rechenmittel (54) eine Ausbreitungszeit im freien Raum der ausgesendeten elektromagnetischen Welle verwenden, die gleich der Ausbreitungszeit zwischen einem räumlichen Referenzpunkt (C, C1) der im Sendebetrieb arbeitenden Antenne (32, 62, 90) und einer Reflexionsebene (P') des Reflexionssystems ist, und eine Ausbreitungszeit im freien Raum der reflektierten elektromagnetischen Welle verwenden, die gleich der Ausbreitungszeit zwischen der Reflexionsebene (P') des Reflexionssystems und einem räumlichen Referenzpunkt (C, C2) der im Empfangsbetrieb arbeitenden Antenne (32, 64, 90) ist.

6. System nach Anspruch 5, das eine einzige Antenne (32, 90) mit zirkulärer Polarisation umfasst, die im Sende- und im Empfangsbetrieb arbeiten kann, **dadurch gekennzeichnet, dass** sich der Referenzpunkt (C) im Zentrum der Phase der Antenne befindet.

7. System nach Anspruch 5, das eine einzige Antenne (32, 90) mit linearer Polarisation umfasst, die im Sende- und im Empfangsbetrieb arbeiten kann, **dadurch gekennzeichnet, dass** der Referenzpunkt (C) gleich einer Referenzstrahleröffnung der Antenne ist.

8. System nach Anspruch 5, die zwei verschiedene Antennen (62, 64) umfasst, die in derselben Sende-/Empfangsebene (P) positioniert sind, **dadurch gekennzeichnet, dass** eine elektromagnetische Welle, die von der Antenne (62) ausgesendet wird, die im Sendebetrieb arbeiten kann, durch das Reflexionssystem (349 in eine reflektierte elektromagnetische Welle reflektiert wird, die von der Antenne (64), die im Empfangsbetrieb arbeitet, empfangen werden kann, wobei die ausgesendeten und reflektierten elektromagnetischen Wellen einen Bistatikwinkel bilden, und dass der Wert des Bistatikwinkels von den Mitteln zum Berechnen der Gruppenausbreitungszeit berücksichtigt wird.

9. Verfahren zum Messen der Gruppenausbreitungszeit einer zu vermessenden Antenne, die im Sende- und/oder Empfangsbetrieb für eine elektromagnetische Welle mit gegebener Polarisation arbeiten kann, das durch ein System zum Messen der Gruppenausbreitungszeit nach Anspruch 1 ausgeführt wird, **dadurch gekennzeichnet dass** es die folgenden Schritte umfasst:

- Aussenden einer elektromagnetischen Welle durch die Sendeantenne zu einem Reflexionssystem mit Polarisationsaufrechterhaltung, wobei das Reflexionssystem mit Polarisationsaufrechterhaltung ein leitendes Zweiflach (34, 66) ist, das eine Mittelkante (40) aufweist, und die Strahlrichtung jeder der Antennen zu der Mittelkante des Zweiflachs zeigt,

- Reflektieren der ausgesendeten elektromagnetischen Welle in eine reflektierte elektromagnetische Welle durch das Reflexionssystem, wobei die reflektierte elektromagnetische Welle dann, wenn die auftreffende elektromagnetische Welle eine Welle mit zirkulärer Polarisation ist, die eine gegebene Polarisationsrichtung hat, die gleiche Polarisationsrichtung wie die auftreffende elektromagnetische Welle hat,
- Empfangen durch die Empfangsantenne einer durch das Reflexionssystem reflektierten elektromagnetischen Welle,
- Messen der Gesamtausbreitungszeit für Hin- und Rücklauf der elektromagnetischen Welle und
- Berechnen der Gruppenausbreitungszeit der zu vermessenden Antenne als Funktion der gemessenen Hin- und Rücklaufzeit und des vorgegebenen Abstands.

10. Verfahren nach Anspruch 9, **dadurch gekennzeichnet, dass** die Sendeantenne und die Empfangsantenne die gleiche Gruppenausbreitungszeit haben.

11. Verfahren nach Anspruch 9, **dadurch gekennzeichnet, dass** das Senden durch eine Sendeantenne ausgeführt wird und das Empfangen durch die zu vermessende Antenne ausgeführt wird, wobei die Sendeantenne eine bekannte Gruppenausbreitungszeit hat.

12. Verfahren nach Anspruch 9, **dadurch gekennzeichnet, dass** das Senden durch die zu vermessende Antenne ausgeführt wird und das Empfangen durch eine Empfangsantenne ausgeführt wird, wobei die Empfangsantenne eine bekannte Gruppenausbreitungszeit hat.

**Claims**

1. System (30, 60, 70, 85) for measuring the group delay of an antenna to be measured which is capable of functioning in transmitting mode and/or in receiving mode for an electromagnetic wave of given polarisation, the system comprising an emitting antenna (62, 80) and a receiving antenna (64, 78), the antennas being connected to an antenna measuring instrument (48, 70, 82, 96),

comprising a reflection system (34, 66, 72, 91), said reflection system being a polarisation-conserving system, comprising at least two elements which affect the path of the electromagnetic wave, positioned in the viewing direction of the antennas, at a predetermined distance from a transmitting or receiving reference plane of the antenna to be measured, **characterised in that** the reflection system (34, 66, 72, 91) is capable of reflecting an incident circularly polarised electromagnetic wave having a given direction of polarisation as a reflected circularly polarised electromagnetic wave having the same direction of polarisation as the incident electromagnetic wave, the polarisation-conserving reflection system being a conducting dihedron (34, 66) having a central edge (40), and the viewing direction of each of the antennas pointing towards the central edge of the dihedron.

2. System according to claim 1, **characterised in that** the polarisation-conserving reflection system (34, 66, 72, 91) comprises an even number of reflecting elements capable of reflecting an incident electromagnetic wave an even number of times.

3. System according to either claim 1 or claim 2, **characterised in that** said measuring instrument (48, 70, 82, 96) is capable of measuring a total round-trip propagation delay of an electromagnetic wave transmitted by the antenna (32, 62, 80, 90) capable of functioning in transmitting mode and received, after reflection by said polarisation-conserving reflection system (34, 66, 72, 91), by the antenna (32, 64, 78, 90) capable of functioning in receiving mode.

4. System according to claim 3, **characterised in that** it comprises calculation means (54) capable of calculating a group delay of said antenna to be measured as a function of the total round-trip propagation delay measured.

5. System according to claim 4, **characterised in that** said calculation means (54) use a propagation delay in free space of the transmitted electromagnetic wave, which is equal to the propagation delay between a spatial reference point (C, C1) of the antenna (32, 62, 90) functioning in transmitting mode and a reflection plane (P') of said reflection system, and a propagation delay in free space of the reflected electromagnetic wave, which is equal to the propagation delay between the reflection plane (P') of said reflection system and a spatial reference point (C, C2) of the antenna (32, 64, 90) functioning in receiving mode.

6. System according to claim 5, comprising a single circularly polarised antenna (32, 90) which is capable of functioning in transmitting mode and in receiving mode, **characterised in that** said reference point (C) is situated at the phase centre of the antenna.

7. System according to claim 5, comprising a single linearly polarised antenna (32, 90) which is capable of functioning in transmitting mode and in receiving mode, **characterised in that** said reference point (C) is a reference opening of the antenna.

8. System according to claim 5, comprising two different antennas (62, 64) positioned in the same transmitting-receiving plane (P), **characterised in that** an electromagnetic wave transmitted by the antenna (62) capable of functioning in transmitting mode is reflected by said reflection system (34) as a reflected electromagnetic wave capable of being received by the antenna (64) functioning in receiving mode, said transmitted and received electromagnetic waves forming a bistatic angle, and **in that** the value of the bistatic angle is taken into consideration by the calculation means for calculating the group delay.

9. Method of measuring the group delay of an antenna to be measured which is capable of functioning in transmitting mode and/or in receiving mode for an electromagnetic wave of given polarisation, which method is carried out by a system for measuring the group delay according to claim 1, **characterised in that** it comprises the following steps:

- transmission of an electromagnetic wave by the transmitting antenna towards a polarisation-conserving reflection system, the polarisation-conserving reflection system being a conducting dihedron (34, 66) having a central edge (40), and the viewing direction of each of the antennas pointing towards the central edge of the dihedron,
- reflection of the transmitted electromagnetic wave as a reflected electromagnetic wave by the reflection system, the reflected electromagnetic wave having, when the incident electromagnetic wave is a circularly polarised wave having a given direction of polarisation, the same direction of polarisation as the incident electromagnetic wave,
- receiving by the receiving antenna of an electromagnetic wave reflected by said reflection system,
- measurement of the total round-trip propagation delay of the electromagnetic wave, and
- calculation of the group delay of the antenna to be measured as a function of the measured round-trip delay and the predetermined distance.

10. Method according to claim 9, **characterised in that** the transmitting antenna and the receiving antenna have an identical group delay.

11. Method according to claim 9, **characterised in that** the transmission is carried out by a transmitting antenna and the receiving is carried out by the antenna to be measured, the transmitting antenna having a known group delay.

12. Method according to claim 9, **characterised in that** the emission is carried out by the antenna to be measured and the receiving is carried out by a receiving antenna, the receiving antenna having a known group delay.

## FIG.1

## FIG.2

## FIG.3

FIG.4

**FIG.5**

Analyseur de réseau vectoriel

**FIG.6**

## RÉFÉRENCES CITÉES DANS LA DESCRIPTION

**Documents brevets cités dans la description**

- US 2006291537 A
- JP 2007033093 B